# EUROPEAN PATENT APPLICATION

(11) **EP 4 412 403 A1**
(43) Date of publication of application: **07.08.2024**
(21) Application number: 22903986.2
(22) Date of filing: 16.11.2022
(51) Int. Cl.: H05K 1/02, H05K 1/09, H05K 3/32

(54) **EXPANDABLE DEVICE**

(30) Priority: 08.12.2021 JP 2021199233
(71) Applicant: Murata Manufacturing Co., Ltd., Nagaokakyo-shi, Kyoto 617-8555 (JP)
(72) Inventor: ITO, Hiromitsu, Nagaokakyo-shi, Kyoto 617-8555 (JP); NISHIDA, Keisuke, Nagaokakyo-shi, Kyoto 617-8555 (JP)
(74) Representative: Thoma, Michael
(86) International application number: PCT/JP2022/042512
(87) International publication number: WO 2023/106055

(57) **Abstract**

One aspect of the present invention provides a stretchable device including a stretchable substrate, a stretchable wiring provided on the stretchable substrate, a conductive member that is in contact with the stretchable wiring, a solder member that is provided on the conductive member and is in contact with the conductive member, an electronic component electrically connected to the conductive member with the solder member interposed therebetween, and a first insulating layer covering at least a part of the stretchable wiring. An outer surface of an end portion, on a side in contact with the conductive member, of the stretchable wiring is in contact with the conductive member and the first insulating layer continuous with the conductive member.

## Description

### TECHNICAL FIELD

The present invention relates to a stretchable device.

### BACKGROUND ART

Conventionally, a stretchable device in which an electronic component connected by a wiring having stretchability is mounted on a substrate having stretchability is widely known. For example, Patent Document 1 describes a stretchable device in which a conductive member having high wettability is provided on a wiring, and an electronic component is mounted on the conductive member with solder interposed therebetween.

### PRIOR ART DOCUMENT

### PATENT DOCUMENT

Patent Document 1: Japanese Patent No. 6518451

### SUMMARY OF THE INVENTION

### Problem to be solved by the invention

In component mounting using solder, there is a possibility of occurrence of a phenomenon called solder corrosion, in which a brittle compound is generated by reaction between solder and a stretchable wiring with an end portion of a conductive member interposed therebetween. A portion where a brittle metal compound is generated is easily broken. In the structure as in Patent Document 1, there is a possibility that solder corrosion of a wiring may occur. In view of the above, an object of the present invention is to provide a stretchable device capable of preventing solder corrosion of a wiring.

### Means for solving the problem

In order to achieve the above object, one aspect of the present invention provides a stretchable device including a stretchable substrate, a stretchable wiring provided on the stretchable substrate, a conductive member that is in contact with the stretchable wiring, a solder member that is provided on the conductive member and is in contact with the conductive member, an electronic component electrically connected to the conductive member with the solder member interposed therebetween, and a first insulating layer covering at least a part of the stretchable wiring. An outer surface of an end portion, on a side in contact with the conductive member, of the stretchable wiring is in contact with the conductive member and the first insulating layer continuous with the conductive member.

### Advantageous effect of the invention

According to the stretchable device according to one aspect of the present invention, solder corrosion of a wiring can be prevented.

### BRIEF EXPLANATION OF DRAWINGS

FIG. 1 is a partial top view of a stretchable device according to a first embodiment.
FIG. 2A is an enlarged perspective view of a stretchable wiring.
FIG. 2B is an enlarged perspective view of the stretchable wiring.
FIG. 3 is a sectional view taken along III-III of FIG. 1.
FIG. 4 is a sectional view taken along IV-IV of FIG. 1.
FIG. 5 is a partial sectional view of the stretchable device according to a first variation of the first embodiment.
FIG. 6 is a partial sectional view of the stretchable device according to a second variation of the first embodiment.
FIG. 7 is a partial sectional view of the stretchable device according to a third variation of the first embodiment.
FIG. 8 is a partial sectional view of the stretchable device according to a fourth variation of the first embodiment.
FIG. 9 is a partial sectional view of the stretchable device according to a fifth variation of the first embodiment.
FIG. 10 is a partial sectional view of the stretchable device according to a second embodiment.
FIG. 11 is a partial sectional view of the stretchable device according to a fourth embodiment.

### MODE FOR CARRYING OUT THE INVENTION

Hereinafter, an embodiment of the present invention will be described in detail with reference to the drawings. In each embodiment, a difference from description before the embodiment will be mainly described. Particularly, similar functions and effects achieved by similar configurations will not be mentioned sequentially for each embodiment. Among constituent elements in an embodiment below, a constituent element not described in an independent claim is described as an optional constituent element. Further, size and a ratio of size of constituent elements illustrated in the drawings are not necessarily strict. Further, in the drawings, substantially the same configurations are denoted by the same reference numerals, and redundant description may be omitted or simplified.

### [First embodiment]

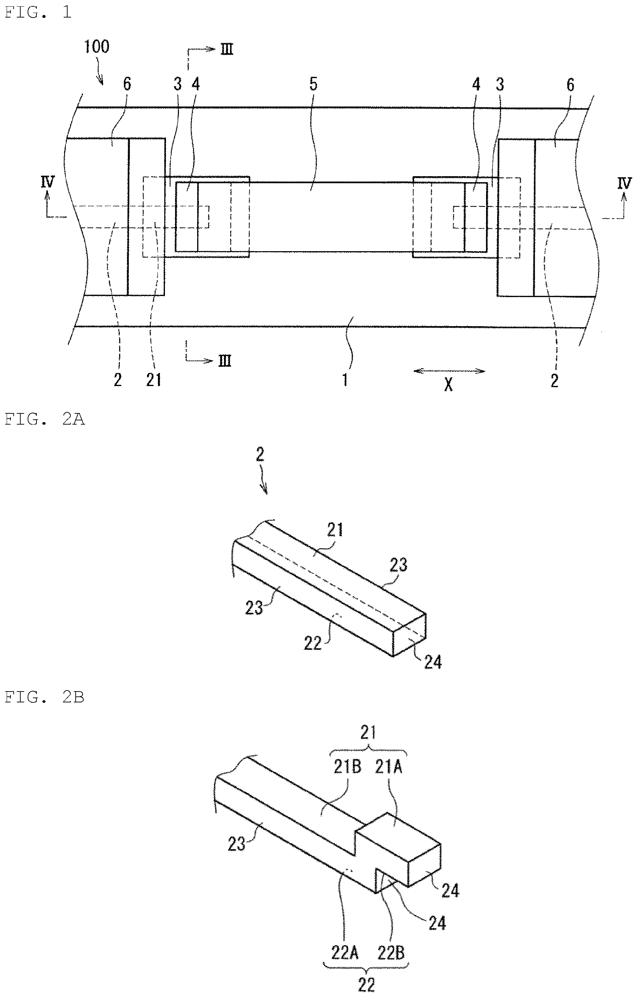

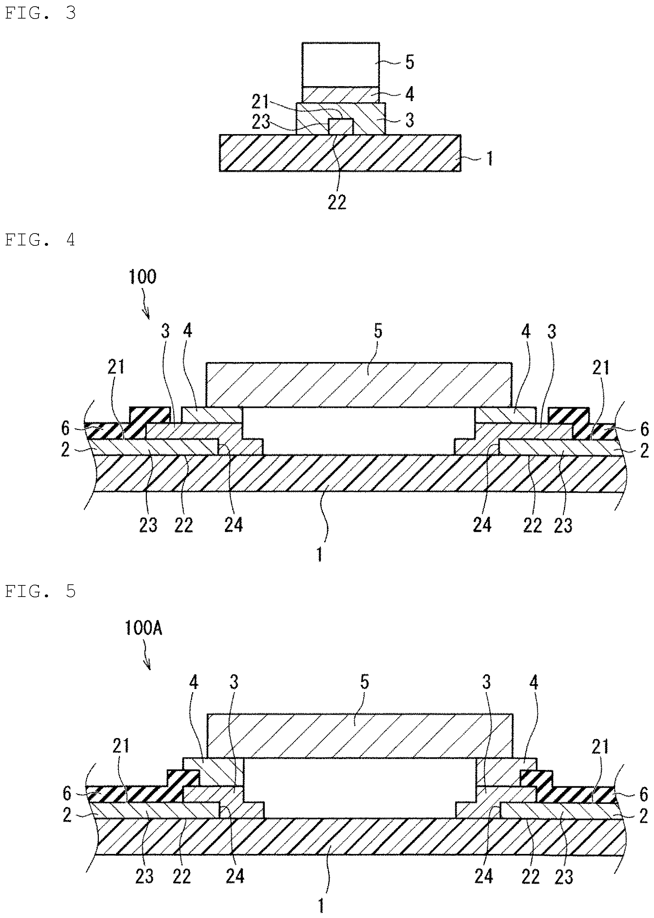

A structure of a stretchable device 100 will be described with reference to FIGS. 1 to 4. FIG. 1 is a partial top view of a stretchable device according to a first embodiment. FIGS. 2A and 2B are enlarged perspective views of a stretchable wiring. FIG. 3 is a sectional view taken along III-III of FIG. 1. FIG. 4 is a sectional view taken along IV-IV of FIG. 1. Note that, as illustrated in FIG. 4, a first insulating layer 6 has a multistage structure, and a portion where a step is generated is indicated by a straight line in FIG. 1.

In the stretchable device 100, a stretchable wiring 2 is laid a stretchable substrate 1, and an electronic component 5 is mounted. FIG. 1 is a partial top view illustrating, in an enlarged manner, a region where the electronic component 5 is mounted. Note that a shape of the stretchable device 100 is not particularly limited, and may be a rectangular shape or a circular shape when viewed from a thickness direction of the stretchable substrate 1. Further, arrangement of the stretchable wiring 2 is not particularly limited. In FIG. 1, a longitudinal direction of the stretchable substrate 1 is indicated by a doubleheaded arrow X. Note that, in the present embodiment, a direction in which the stretchable device 100 expands and contracts coincides with the longitudinal direction of the stretchable substrate 1, but does not need to coincide with the longitudinal direction.

The stretchable device 100 includes the stretchable substrate 1, the stretchable wiring 2 provided on the stretchable substrate 1, a conductive member 3 in contact with the stretchable wiring 2, a solder member 4 provided on the conductive member 3 and in contact with the conductive member 3, the electronic component 5 electrically connected to the conductive member 3 with the solder member 4 interposed therebetween, and the first insulating layer 6 covering at least a part of the stretchable wiring 2.

Hereinafter, arrangement of these constituent elements will be described with reference to FIGS. 1 and 4. As illustrated in FIG. 1, the stretchable wiring 2 is provided on the stretchable substrate 1. Further, as illustrated in FIG. 4, the conductive member 3 is in contact with an upper surface 21 and an end surface 24 of the stretchable wiring 2.

The stretchable substrate 1 is a sheet-shaped or film-shaped stretchable substrate, which is made from, for example, a resin material having stretchability. Examples of the resin material include thermoplastic polyurethane. Thickness of the stretchable substrate 1 is not particularly limited, but is preferably 1 mm or less, more preferably 100 um or less, still more preferably 50 um or less from the viewpoint of preventing stretchability of a surface of a living body from being impaired when the stretchable substrate 1 is attached to the living body. Further, thickness of the stretchable substrate 1 is preferably 1 um or more.

The stretchable wiring 2 is indicated as a portion directly connected to the electronic component 5 in the stretchable wiring 2 laid in a predetermined pattern on a main surface of the stretchable substrate 1. That is, the stretchable device 100 may have a wiring that is not connected to the electronic component 5. The stretchable wiring 2 contains a conductive particle and resin. For example, a mixture of metal powder of Ag, Cu, Ni, and the like as ta conductive particle and elastomer-based resin such as silicone resin is used. An average particle size of the conductive particle is not particularly limited, but is preferably 0.01 um or more and 10 um or less. Further, the conductive particle preferably has a spherical shape.

Thickness of the stretchable wiring 2 is not particularly limited, but is preferably 100 um or less, and more preferably 50 um or less. Further, thickness of the stretchable wiring 2 is preferably 0.01 um or more. A line width of the stretchable wiring 2 is not particularly limited, but is preferably 0.1 um or more and more preferably 10 mm or less. Further, the number of the stretchable wirings 2 included in the stretchable wirings 2 is not particularly limited.

As the conductive member 3, it is preferable to use a material that is less likely to have solder corrosion than the stretchable wiring 2. Specifically, the conductive member 3 preferably contains thermosetting resin. Examples of the conductive member 3 containing thermosetting resin include a compound of a metal filler and resin including thermosetting resin. Further, examples of the metal filler include a silver filler, a copper filler, and a nickel filler. As described above, since the conductive member 3 contains thermosetting resin, solder corrosion due to a reaction between the stretchable wiring 2 and the solder member 4 can be prevented. Note that, for the conductive member 3, metal foil, metal plating, or the like may be used.

The solder member 4 is not particularly limited, but preferably contains tin and bismuth as metal components, and is preferably what is called low-temperature solder. By using low-temperature solder, in a case where a heat resistant temperature of the stretchable substrate 1, the stretchable wiring 2, and the electronic component 5 is low, mounting of the electronic component 5 can be performed without damaging these components.

The electronic component 5 is not particularly limited, and examples of the electronic component 5 include an amplifier (an operational amplifier, a transistor, or the like), a diode, an integrated circuit (IC), a capacitor, a resistor, and an inductor.

The first insulating layer 6 is preferably a resin material or a mixture of a resin material and an inorganic material, and examples of the resin material include elastomer-based resin such as urethane-based, styrene-based, olefin-based, silicone-based, fluorine-based, nitrile rubber, latex rubber, vinyl chloride, ester-based, and amide-based resin, and epoxy, phenol, acrylic, polyester, imide-based, rosin, cellulose, polyethylene terephthalate-based, polyethylene naphthalate-based, and polycarbonate-based resin.

Further, an outer surface of an end portion, on the side in contact with the conductive member 3, of the stretchable wiring 2 is in contact with the conductive member 3 and the first insulating layer 6 continuous with the conductive member 3.

In the present description, an outer surface refers to a surface excluding a surface on the substrate side of a surface of the stretchable wiring 2. Specific description will be made with reference to FIG. 2A. As illustrated in FIG. 2A, for example, a surface of the stretchable wiring 2 includes an upper surface 21, a lower surface 22, a side surface 23, and an end surface 24. In the present specification, a lower surface refers to a surface closest to the stretchable substrate 1, and an upper surface refers to a surface facing the lower surface. In the stretchable device 100 according to the first embodiment, the upper surface 21 is in contact with the conductive member 3, and the lower surface 22 is in contact with the stretchable substrate 1. Note that the stretchable wiring 2 is not limited to a rectangular parallelepiped shape as illustrated in FIG. 2A, and may have a curved surface or unevenness. Similarly, each surface does not need to have a rectangular shape, and may have a corner portion having R.

Note that the stretchable wiring 2 may have a multistage structure as illustrated in FIG. 2B. In a case where the stretchable wiring 2 has a multistage structure, there is a plurality of the upper surfaces 21 and the lower surfaces 22. In such a case, as illustrated in FIG. 2B, in a thickness direction of the stretchable substrate 1, an upper surface closest to the electronic component 5 is defined as an uppermost surface 21A, and an upper surface second closest to the electronic component 5 is defined as a second upper surface 21B. Note that the stretchable wiring 2 may include a third upper surface, and the number of upper surfaces is not particularly limited.

Further, as for the lower surface 22, a lower surface closest to the stretchable substrate 1 in the thickness direction of the stretchable substrate 1 is defined as a lowermost surface 22A, and a lower surface second closest to the stretchable substrate 1 is defined as a second lower surface 22B. Note that the stretchable wiring 2 may include a third lower surface, and the number of lower surfaces is not particularly limited.

In a case of the structure as illustrated in FIG. 2B, a surface closest to the substrate 1 is the lowermost surface 22A. That is, the second lower surface 22B is included in an outer surface, but the lowermost surface 22A is not included in the outer surface. Similarly, if the stretchable wiring 2 has a third lower surface or a fourth lower surface, these surfaces are not included in the outer surface.

The upper surface 21 and the lower surface 22 do not need to coincide with actual upper and lower surfaces. These are names for convenience of description, and a lower surface may be arranged further on the upper side than an upper surface when the stretchable device 100 is used. Note that the lower surface 22 and the stretchable substrate 1 do not need to be in contact with each other. As described later, an insulating layer or a thin film may be arranged between the lower surface 22 and the stretchable substrate 1.

The side surface 23 and the end surface 24 connect the upper surface 21 and the lower surface 22. The stretchable wiring 2 includes two of the side surfaces 23 and two end surfaces, but one of the two end surfaces is not illustrated in FIGS. 2A and 2B. Note that, in the present description, an end surface of the stretchable wiring 2 in contact with the conductive member 3 is defined as 24. An outer surface of the entire stretchable wiring 2 is constituted by the upper surface 21, the side surface 23, and both end surfaces, and an outer surface of an end portion, on the side in contact with the conductive member 3, of the stretchable wiring 2 is constituted by the upper surface 21, the side surface 23, and the end surface 24. Note that the end portion, on the side in contact with the conductive member 3, of the stretchable wiring 2 preferably includes up to an end portion (referred to as an end portion A) farther from the end surface 24 in both end portions in an extending direction of a wiring of the conductive member 3 from the end surface 24, and more preferably includes 0.5 mm in addition to up to the end portion A, and more preferably includes 1 mm in addition to up to the end portion A. With such a structure, it is possible to more reliably prevent contact between the stretchable wiring 2 and the solder member 4.

Further, each surface of each constituent element other than the stretchable wiring 2 is similarly determined. Note that, in the present description, the upper surface 21 of the stretchable wiring 2 is simply described as the upper surface 21. In other words, In a case where each surface is denoted by a reference symbol, each surface of the stretchable wiring 2 is indicated. Surfaces of the other constituent elements will be described without omission from description and without reference symbols.

With such a structure, an outer surface of the stretchable wiring 2 is covered with the conductive member 3 and the first insulating layer 6. That is, since the stretchable wiring 2 and the solder member 4 are less likely to come into contact with each other, solder corrosion can be prevented, and reliability of 100 can be enhanced.

Further, the first insulating layer 6 is continuous with the conductive member 3. In other words, as illustrated in FIG. 4, the first insulating layer 6 and the conductive member 3 are in contact with each other. If the first insulating layer 6 and the conductive member 3 are not in contact with each other, the solder member 4 may come into contact with the stretchable wiring 2 from a surface of the conductive member 3 with an end surface interposed therebetween, the end surface being provided on the stretchable wiring 2 of both end surfaces of the conductive member 3. Since the first insulating layer 6 and the conductive member 3 are continuous, occurrence of solder corrosion can be prevented.

Note that, that the conductive member 3 and the first insulating layer 6 are continuous means that, only an end surface of the conductive member 3 and an end surface of the first insulating layer 6 may be in contact with each other, but the first insulating layer 6 preferably overlaps an end portion of the conductive member 3 in plan view. In other words, as illustrated in FIG. 4, a part of the first insulating layer 6 is preferably provided on the conductive member 3. Wet spreading of the solder member 4 stops at a contact portion with the first insulating layer 6. That is, with such a structure, wet spreading of the solder member 4 can be prevented. Note that the first insulating layer 6 and the solder member 4 may be in contact with each other or may not be in contact with each other as illustrated in FIG. 4.

Further, since the first insulating layer 6 is provided on the conductive member 3, the conductive member 3 can be prevented from moving to the electronic component side. In other words, connection performance between the conductive member 3 and the stretchable wiring 2 can be improved. When the stretchable device 100 expands and contracts in the extending direction of the stretchable wiring 2, it is conceivable that the stretchable wiring 2 and the conductive member 3 are peeled off from each other due to a difference in amounts of expansion and contraction. By providing the first insulating layer 6 on the conductive member 3, connection performance between the stretchable wiring 2 and the conductive member 3 can be improved, and peeling off can be prevented.

Note that, as illustrated in FIG. 1, a width direction length of the stretchable wiring 2 is preferably smaller than the width direction length of the conductive member 3. With such a structure, the conductive member 3 comes into contact with both of the side surfaces 23 of the stretchable wiring 2, and it is possible to prevent contact between the stretchable wiring 2 and the solder member 4. Therefore, reliability of connection is enhanced.

From the viewpoint of connectivity, a contact area between the stretchable wiring 2 and the conductive member 3 is preferably large. That is, as illustrated in FIGS. 3 and 4, the conductive member 3 is preferably in contact with the upper surface 21, both of the side surfaces 23, and the end surface 24 of the wiring. Note that the entire conductive member 3 may be provided on the stretchable wiring 2.

The solder member 4 is in contact with an upper surface of the conductive member 3. Note that the solder member 4 may be in contact with a surface other than the upper surface of the conductive member 3. Specifically, when viewed from the thickness direction of the stretchable substrate 1, the solder member 4 may be in contact with an end surface or both side surfaces that do not overlap the stretchable wiring 2 of the conductive member 3. Further, the solder member 4 may be in contact with the stretchable substrate 1. Further, the shape of the solder member 4 is not particularly limited. For example, the solder member 4 may have a fillet.

Since the solder member 4 wet-spreads, it is difficult to accurately control the area. That is, as described above, when the solder member 4 is arranged so as to be in contact with a surface of the conductive member 3 overlapping the stretchable wiring 2 as viewed from the thickness direction of the stretchable substrate 1, there is a possibility that the solder member 4 unintentionally wet-spreads, the stretchable wiring 2 and the solder member 4 come into contact with each other, and solder corrosion occurs.

The electronic component 5 is electrically connected to the conductive member 3 and the stretchable wiring 2 with the solder member 4 interposed therebetween. Note that, as illustrated in FIGS. 1 and 4, the electronic component 5 is electrically connected to two of the stretchable wirings 2, but may be electrically connected to, for example, four of the stretchable wirings 2.

Although the first insulating layer 6 covers at least a part of the stretchable wiring 2 and size of the first insulating layer 6 is not particularly limited, the first insulating layer 6 preferably covers the entire stretchable wiring 2. Note that, as illustrated in FIG. 1, in addition to the entire stretchable wiring 2, the first insulating layer 6 may be provided so as to be in contact with a portion of the stretchable substrate 1, or may cover the entire stretchable substrate 1.

Further, an outer surface of an end portion, on the side in contact with the conductive member 3, of the stretchable wiring 2 is in contact with the conductive member 3 and the first insulating layer 6. As described above, an outer surface of the stretchable wiring 2 is the upper surface 21, both of the side surfaces 23, and the end surface 24 in contact with the conductive member 3.

As illustrated in FIG. 3, since the width direction length of the stretchable wiring 2 is smaller than the width direction length of the conductive member 3, the conductive member 3 and both of the side surfaces 23 are in contact with each other. In a case of such a structure, if the solder member 4 provided on an upper surface of the conductive member 3 wet-spreads, the solder member 4 does not come into contact with both of the side surfaces 23. Note that the conductive member 3 does not need to be in contact with the entirety of both of the side surfaces 23, and does not need to be in partial contact.

Similarly, as for the end surface 24, if the solder member 4 wet-spreads via an end surface on the side in contact with the stretchable substrate 1 of the conductive member 3, the solder member 4 and the end surface 24 do not come into contact with each other. Note that the conductive member 3 does not need to be in contact with the entire end surface 24, and only a part of the conductive member 3 needs to be in contact.

The upper surface 21 is in contact with the conductive member 3 and the first insulating layer 6 continuous with the conductive member 3. As described above, with such a structure, it is possible to prevent contact between the solder member 4 and the stretchable wiring 2 with an end surface interposed therebetween, the end surface being provided on the stretchable wiring 2 of both end surfaces of the conductive member 3. That is, with the above configuration, it is possible to prevent contact between the solder member 4 and the stretchable wiring 2 with both side surfaces and both end surfaces of the conductive member 3 interposed therebetween, and to enhance reliability of the stretchable device 100.

Note that the first insulating layer 6 is preferably in contact with an end portion of the conductive member 3. In other words, the first insulating layer 6 is preferably in contact with one end surface, both side surfaces, and an upper surface of the conductive member 3. With this arrangement, it is possible to prevent contact between the solder member 4 and the stretchable wiring 2 with an end portion of the conductive member 3 interposed therebetween.

Further, in a case where the stretchable device 100 stretches and contracts at the time of use, peeling may occur at an interface of each constituent element. When the first insulating layer 6 is provided on the conductive member 3, the first insulating layer 6, the conductive member 3, and the stretchable wiring 2 overlap when viewed from the thickness direction of the substrate. With such arrangement, movement of the conductive member 3 in an upward direction can be prevented by the first insulating layer 6. Therefore, an interface between the upper surface 21 and the conductive member 3 can reduce upward and downward peeling.

Note that thickness of each constituent element is not limited to that illustrated in FIG. 4. In FIG. 4, thickness of the first insulating layer 6 is larger than thickness of the stretchable wiring 2, but it may be vice versa. Further, in the first insulating layer 6, thickness of a portion provided on the stretchable wiring 2 and thickness of a portion provided on the conductive member 3 may be the same or different. In the conductive member 3, thickness of a portion provided on the stretchable wiring 2 and thickness of a portion provided on the stretchable substrate 1 may be the same or different.

### [First variation of first embodiment]

FIG. 5 is a partial sectional view of a stretchable device 100A according to a first variation of the first embodiment. The stretchable device 100A differs from the stretchable device 100 according to the first embodiment in arrangement of the conductive member 3 and the solder member 4.

Further, a part of the first insulating layer 6 is preferably in contact with both the conductive member 3 and the solder member 4. As described above, when the stretchable wiring 2 and the solder member 4 come into contact with each other, there is a possibility that solder corrosion occurs. Similarly, in a case where the conductive member 3 and the solder member 4 come into contact with each other, there is a possibility that solder corrosion occurs also on the conductive member 3. The larger a contact area between the conductive member 3 and the solder member 4, the higher the possibility that solder corrosion occurs in the conductive member 3.

However, connection performance of the solder member 4 is greatly affected by a contact area with another member. That is, when a contact area of the solder member 4 is small, there is a higher risk that an interface of the solder member 4 is broken at the time of expansion and contraction, and a defect is generated. That is, it is preferable to increase a contact area of the solder member 4 without increasing a contact area between the conductive member 3 and the solder member 4.

By increasing a connection area between the solder member 4 and a member where solder corrosion hardly occurs, solder corrosion of the conductive member 3 can be prevented, and by increasing a contact area of the solder member 4, breakage of an interface of the solder member 4 during expansion and contraction can be prevented. With the structure as described above, a contact area between the first insulating layer 6 where solder corrosion hardly occurs and the solder member 4 is increased.

Further, the first insulating layer 6, the conductive member 3, and the solder member 4 preferably overlap each other in plan view. The above-described portion also overlaps the stretchable wiring 2 in plan view. That is, the possibility that the stretchable wiring 2 and the conductive member 3 are broken in upward and downward directions can be further reduced.

Further, the solder member 4 is more preferably in contact with the first insulating layer 6 in an extending direction of a wiring. In a case where the conductive member 3 has poorer stretchability than the stretchable wiring 2, such as a case where the conductive member 3 contains thermosetting resin, if an area of the conductive member 3 in plan view is increased, stretchability of the stretchable device 100A is greatly reduced. However, when an area of the conductive member 3 is reduced, a connection area with the solder member 4 is also reduced, and connection performance is lowered. Since the solder member 4 is in contact with the first insulating layer 6 in an extending direction of a wiring, a connection area between the solder member 4 and the conductive member 3 can be increased, and connection performance can be improved.

Similarly, the entire solder member 4 preferably overlaps the conductive member 3 in plan view. A connection area between the conductive member 3 and the solder member 4 can be increased, and connection performance can be improved.

Further, as illustrated in FIG. 5, a part of the first insulating layer 6 is more preferably arranged between the solder member 4 and the conductive member 3. As illustrated in FIG. 5, since a part of an upper surface, in addition to an end surface of an insulating layer, is also in contact with the solder member 4, a contact area of the solder member 4 increases. That is, peeling of the solder member 4 can be prevented, and a contact area between the solder member 4 and the conductive member 3 can be increased. Note that a part of the solder member 4 may be arranged between the conductive member 3 and the first insulating layer 6.

Note that thickness of the first insulating layer 6 arranged between the conductive member 3 and the solder member 4 is not particularly limited. The thickness may be the same as or different from thickness of the first insulating layer 6 provided on the stretchable wiring 2.

### [Second variation of first embodiment]

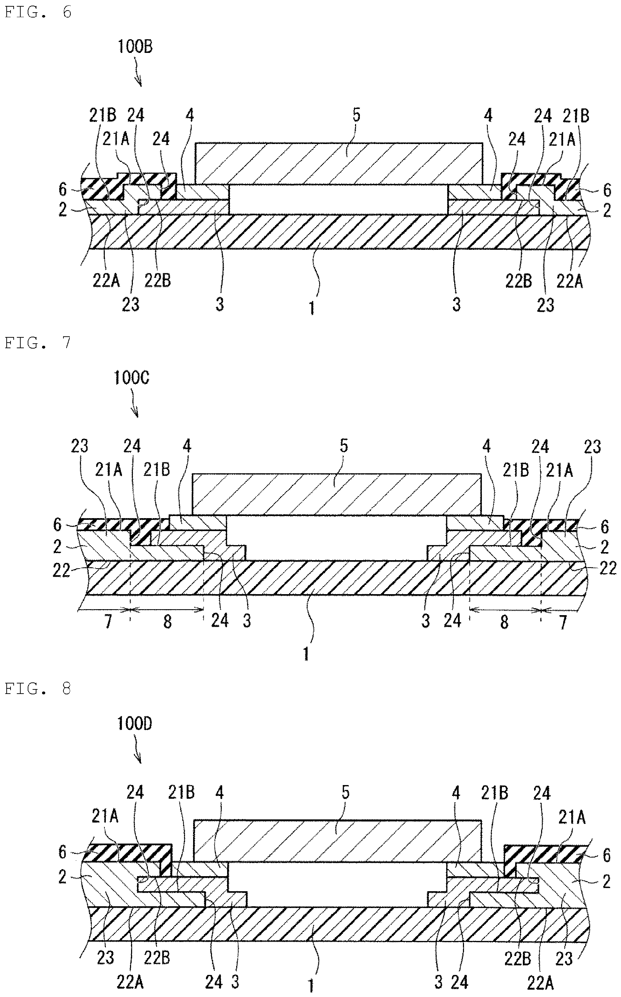

FIG. 6 is a partial sectional view of a stretchable device 100B according to a second variation of the first embodiment. The stretchable device 100B is different from the stretchable device 100 according to the first embodiment in arrangement of the stretchable wiring 2 and the conductive member 3.

As illustrated in FIG. 6, on the stretchable device 100B, Part of the stretchable wiring 2 are arranged on the conductive member 3, and the first insulating layer 6 is arranged between a part of the stretchable wiring 2 and the solder member 4 in the longitudinal direction of the stretchable substrate 1. With such a configuration, since one end surface and an upper surface of the conductive member 3 come into contact with the stretchable wiring 2, it is possible to prevent breakage at the time of expansion and contraction.

Note that in a case where a part of the stretchable wiring 2 is present on the conductive member 3 as described above, the first insulating layer 6 is preferably arranged between the stretchable wiring 2 and the solder member 4 in order to prevent contact between them. The first insulating layer 6 can prevent solder corrosion of the stretchable wiring 2.

Further, by the arrangement as described above, it is possible to make thickness of the conductive member 3 close to uniform while increasing a contact area between the stretchable wiring 2 and the conductive member 3. As illustrated in FIG. 6, the electronic component 5 overlaps the stretchable substrate 1, the conductive member 3, and the solder member 4 in plan view. That is, flatness of the electronic component 5 is determined by these three members. If flatness of the electronic component 5 is impaired, reliability of a component is lowered. That is, with such a structure, it is possible to prevent lowering in reliability of a component while increasing a contact area between the stretchable wiring 2 and the conductive member 3.

A shape of the first insulating layer 6 is not particularly limited, and as illustrated in FIG. 6, the first insulating layer 6 may have a constant thickness so as to have a shape corresponding to unevenness of the conductive member 3, or the first insulating layer 6 may have a matching upper surface height by performing printing by changing thickness.

### [Third variation of first embodiment]

FIG. 7 is a partial sectional view of a stretchable device 100C according to a third variation of the first embodiment. The stretchable device 100C is different from the stretchable device 100 according to the first embodiment in the first insulating layer 6.

As illustrated in FIG. 7, in the stretchable device 100C, a part of the stretchable wiring 2 is arranged under the conductive member 3. With such arrangement, the upper surface 21 and the end surface 24 come into contact with the stretchable wiring 2. That is, it is possible to increase a contact area between the stretchable wiring 2 and the conductive member 3 and to prevent breakage at the time of expansion and contraction.

Further, preferably, the stretchable wiring 2 includes a first portion 7 having a large thickness and a second portion 8 having a smaller thickness than the first portion 7, and at least a part of the second portion 8 is arranged under the conductive member 3. As described above, a part of the stretchable wiring 2 is arranged under the conductive member 3, so that the upper surface 21 and the end surface 24 can be arranged in contact with the conductive member 3.

In plan view, a shortest distance from the stretchable substrate 1 is different between a portion overlapping the stretchable wiring 2 in the conductive member 3 and a portion not overlapping the stretchable wiring 2 by a thickness of the second portion 8. That is, when the thickness of the second portion 8 is large, unevenness of the conductive member 3 is large, and flatness is impaired.

That is, by arranging at least a part of the second portion 8 having a small thickness in the stretchable wiring 2 under the conductive member 3, it is possible to increase a contact area between the stretchable wiring 2 and the conductive member 3, and prevent impairment of flatness of the conductive member 3. Further, a height of a region where the electronic component 5 is mounted can be lowered.

Note that length of the second portion 8 is not particularly limited. As illustrated in FIG. 7, a part of the second portion 8 may be arranged under the conductive member 3, or the entire second portion 8 may be arranged under the conductive member 3.

### [Fourth variation of first embodiment]

FIG. 8 is a partial sectional view of a stretchable device 100D according to a fourth variation of the first embodiment. The stretchable device 100D is different from the stretchable device 100 according to the first embodiment in arrangement of the stretchable wiring 2 and the first insulating layer 6.

A part of the stretchable wiring 2 is preferably in contact with each of an upper surface and a lower surface of the conductive member 3. Specifically, as illustrated in FIG. 8, the stretchable wiring 2 is preferably bifurcated, and the conductive member 3 is preferably arranged between them.

For example, after the stretchable wiring 2 is printed once, the conductive member 3 is printed so as to overlap a part of the stretchable wiring 2, and the stretchable wiring 2 is printed again, so that a structure as illustrated in FIG. 8 can be obtained. Note that the above-described printing method is merely an example, and a different manufacturing method may be used.

With the above structure, the stretchable wiring 2 comes into contact with one end surface, an upper surface, and a lower surface of the conductive member 3. That is, a contact area increases, and reliability at the time of connection is improved. Further, as described above, the stretchable wiring 2 in contact with an upper surface of the conductive member 3 can prevent peeling between the conductive member 3 and the stretchable wiring 2 in contact with a lower surface of the conductive member 3.

Similarly, the stretchable wiring 2 in contact with a lower surface of the conductive member 3 can prevent peeling between the conductive member 3 and the stretchable wiring 2 in contact with an upper surface of the conductive member 3. In other words, since the stretchable wiring 2 is arranged above and under the conductive member 3, it is possible to prevent variation of the conductive member 3. Furthermore, since the stretchable wiring 2 is in contact with an upper surface and a lower surface of the conductive member 3, if one of the contact portions is peeled off, electrical connection can be secured at the other contact portion.

Note that in the stretchable wiring 2, thicknesses of a portion in contact with an upper surface of the conductive member 3 and a portion in contact with a lower surface may be the same or different. Further, the length is not particularly limited, and as illustrated in FIG. 8, a portion in contact with a lower surface of the conductive member 3 may be longer than or the same as a portion in contact with an upper surface of the conductive member 3, or the portion in contact with the upper surface may be longer.

Further, the first insulating layer 6 is arranged between a part of the stretchable wiring 2 and the solder member 4 in the longitudinal direction of the stretchable substrate 1. With such a configuration, since one end surface and an upper surface of the conductive member 3 come into contact with the stretchable wiring 2, it is possible to prevent breakage at the time of expansion and contraction.

### [Fifth variation of first embodiment]

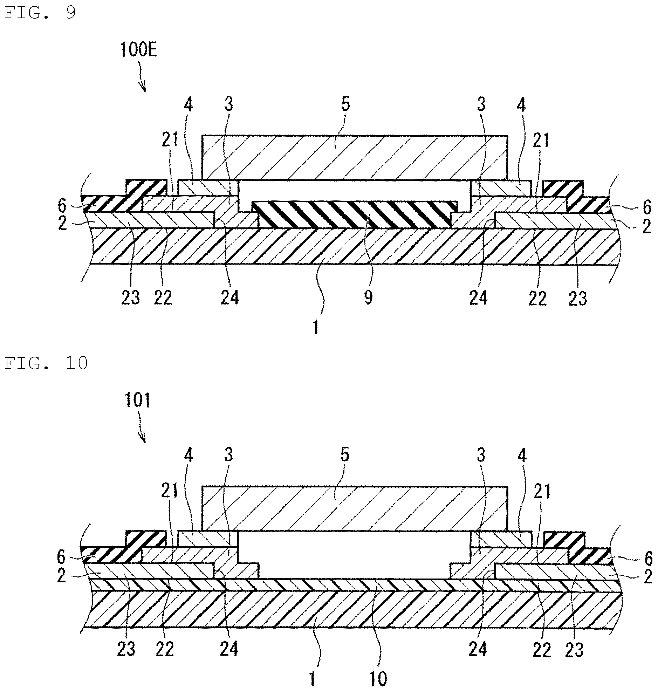

FIG. 9 is a partial sectional view of a stretchable device 100E according to a fifth variation of the first embodiment. The stretchable device 100E is different from the stretchable device 100 according to the first embodiment in including a second insulating layer 9.

The second insulating layer 9 is preferably a resin material or a mixture of a resin material and an inorganic material, and examples of the resin material include elastomer-based resin such as urethane-based, styrene-based, olefin-based, silicone-based, fluorine-based, nitrile rubber, latex rubber, vinyl chloride, ester-based, and amide-based resin, and epoxy, phenol, acrylic, polyester, imide-based, rosin, cellulose, polyethylene terephthalate-based, polyethylene naphthalate-based, and polycarbonate-based resin. The material may be the same as or different from that of the first insulating layer 6.

The second insulating layer 9 is preferably further included, and the second insulating layer 9 is preferably in contact with an end portion on the side opposite to the side in contact with the first insulating layer 6 with reference to the conductive member 3. As described above, it is preferable to provide the first insulating layer 6 so as to overlap the conductive member 3 in order to prevent peeling between the conductive member 3 and the upper surface 21. The second insulating layer 9 can prevent peeling between the conductive member 3 and the end surface 24.

Specifically, as illustrated in FIG. 9, the second insulating layer 9 is arranged in an end portion on the side overlapping the electronic component 5 in plan view of the conductive member 3. With such arrangement, it is possible to prevent movement of the conductive member 3 in a direction opposite to the stretchable wiring 2. That is, peeling between the conductive member 3 and the end surface 24 can be prevented.

Further, a part of the second insulating layer 9 is preferably provided on an end portion of the conductive member 3, and a part of the second insulating layer 9 is further preferably arranged between the solder member 4 and the conductive member 3. Similarly to the first insulating layer 6, peeling can be prevented by increasing a connection area with the conductive member 3 or the solder member 4. Further, the second insulating layer 9 is preferably in contact with the solder member 4 in an extending direction of a wiring. Similarly to the first insulating layer 6, areas of the solder member 4 and the conductive member 3 can be maximized.

Further, since a part of the second insulating layer 9 is provided on an end portion of the conductive member 3, the conductive member 3 can be prevented from moving in a direction of the electronic component 5. That is, peeling between the stretchable substrate 1 and the conductive member 3 can be prevented.

Further, a pair of the stretchable wirings 2 separated from and facing each other are preferably provided, and the second insulating layer 9 is preferably in contact with each of an end portion on the side opposite to the side in contact with the first insulating layer 6 with reference to the conductive member 3 in contact with one of the stretchable wirings 2 and an end portion on the side opposite to the side in contact with the first insulating layer 6 with reference to the conductive member 3 in contact with the other one of the stretchable wirings 2.

Specifically, as illustrated in FIG. 9, a plurality of the conductive members 3 in contact with a plurality of the stretchable wirings 2 are provided, and the second insulating layer 9 is in contact with a plurality of the conductive members 3. By providing the integrated first insulating layer with respect to the stretchable wiring 2 separated from and facing each other in this manner, peeling between them can be further prevented by the law of action and reaction.

That is, when force that causes one of the conductive members 3 and the first insulating layer 6 to peel off in the longitudinal direction of the stretchable substrate 1 acts, another one of the conductive members 3 can prevent the peeling. In a case where the another one of the conductive members 3 and the first insulating layer 6 peel off in the longitudinal direction of the stretchable substrate 1, the one of the conductive members 3 and the first insulating layer 6 prevents peeling. Note that a contact portion that may peel off in the longitudinal direction of the stretchable substrate 1 is not limited to the conductive member 3 and the first insulating layer 6. For example, as illustrated in FIG. 9, it is possible to prevent peeling of a connection portion between the end surface 24 and the conductive member 3 in the longitudinal direction of the stretchable substrate 1. Note that the longitudinal direction of the stretchable substrate 1 in which peeling easily occurs, that is, an expansion and contraction direction is described, but a direction of facing and separated from each other is not particularly limited.

Further, as described above, the number of the stretchable wirings 2 connected to the electronic component 5 is not particularly limited. In a case where there is a plurality of sets of the stretchable wirings 2 separated from and facing each other, it is preferable to provide the second insulating layer 9 for each of the sets, and it is preferable to provide the second insulating layer 9 in contact with all the conductive members 3. That is, since unevenness of a region overlapping the electronic component 5 in plan view is reduced, the electronic component 5 can be stably arranged.

### [Second embodiment]

FIG. 10 is a partial sectional view of a stretchable device 101 according to a second embodiment. The stretchable device 101 is different from the stretchable device 100 according to the first embodiment in including a protective layer 10.

The protective layer 10 is a layer for protecting the stretchable wiring 2 from moisture. When the stretchable wiring 2 absorbs moisture, there is a possibility that ion migration occurs, and a short circuit occurs due to energization with a wiring having a different potential. By providing the protective layer 10, it is possible to prevent ion migration of the stretchable wiring 2.

The protective layer 10 is preferably a resin material or a mixture of a resin material and an inorganic material, and examples of the resin material include elastomer-based such as urethane-based, styrene-based, olefin-based, silicone-based, fluorine-based, nitrile rubber, latex rubber, vinyl chloride, ester-based, and amide-based resin, and epoxy, phenol, acrylic, polyester, imide-based, rosin, cellulose, polyethylene terephthalate-based, polyethylene naphthalate-based, and polycarbonate-based resin. The material may be the same as or different from that of the first insulating layer 6 and the second insulating layer 9.

From the viewpoint of water absorbency as the protective layer 10, it is preferable to select a member having a high water absorption rate for the protective layer 10. Further, by selecting the same member for the first insulating layer 6, the second insulating layer 9, and the protective layer 10, a member covering an outer surface of the stretchable wiring 2 is the same except for the conductive member 3, so that formation at the time of printing is facilitated, and the risk of generation of a defect can be reduced.

Note that, as illustrated in FIG. 10, the protective layer 10 may be integrally arranged so as to be in contact with the lower surfaces 22 of a plurality of the stretchable wirings 2, or may be arranged separately for each of the stretchable wirings 2. Further, preferably, the protective layer 10 is arranged between the conductive member 3 and the stretchable substrate 1. A contact area of the conductive member 3 can be increased, and breakage can be prevented.

### [Third embodiment]

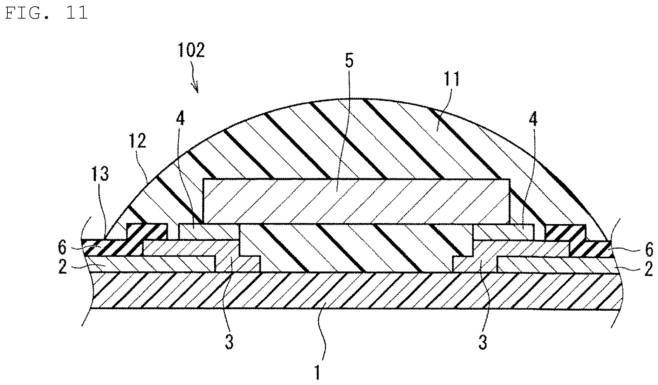

FIG. 11 is a partial sectional view of a stretchable device 102 according to a third embodiment. The stretchable device 102 is different from the stretchable device 100 according to the first embodiment in including a resin layer 11.

As illustrated in FIG. 11, the resin layer 11 covering the electronic component 5 is further provided. The resin layer 11 can protect the electronic component 5 from external force.

As a material of the resin layer 11, there are polyvinyl chloride, polyethylene, polystyrene, polycarbonate, polyvinylidene fluoride, polyimide, liquid crystal polymer, polytetrafluoroethylene, and elastomer-based resin such as phenol resin, epoxy-based resin, urethane-based resin, acrylic-based resin, silicone-based resin, and styrene-butadiene-based resin.

When the resin layer 11 is provided, the stretchable device 100 contracts as resin contained in the resin layer 11 is cured. That is, there is a possibility that an interface of each constituent element of the stretchable device 100 is peeled off at the time of contraction. As described above, by providing the first insulating layer 6 on the conductive member 3, it is possible to prevent peeling due to contraction at the time of resin effect. The same applies to other peeling prevention effects.

The resin layer 11 preferably overlaps the entire solder member 4 in plan view, and more preferably overlaps the entirety of the solder member 4 and the conductive member 3. In other words, a surface 12 of the resin layer 11 is preferably in contact with the conductive member 3, and the surface 12 of the resin layer 11 is more preferably in contact with the first insulating layer 6. In FIG. 11, a contact portion between the surface 12 of the resin layer 11 and the first insulating layer 6 is illustrated as a contact 13. With such arrangement, it is possible to prevent breakage by employing the structure as described above.

Since the resin layer 11 has a role of protecting the electronic component 5 from external force, the resin layer 11 is inferior in stretchability to the stretchable wiring 2. Therefore, an amount of expansion and contraction greatly changes at an interface between a portion overlapping the resin layer 11 and a portion not overlapping the resin layer 11 in plan view. In a portion where an amount of expansion and contraction greatly changes, stress tends to concentrate, and therefore breakage tends to occur. More specifically, in a structure in which a part of the solder member 4 overlaps the resin layer 11 and a part of the solder member 4 does not overlap the resin layer 11 in plan view, the solder member 4 may be broken. The same applies to the conductive member 3.

On the other hand, as the resin layer 11 is arranged so as to overlap the entire solder member 4 in plan view, the solder member 4 is included in the resin layer. That is, since an amount of expansion and contraction of the entire solder member 4 becomes close to uniform, breakage of the solder member 4 can be prevented. The same applies to the conductive member 3.

Note that in each embodiment and each variation described above, the first insulating layer 6 covers the conductive member 3. The present invention is not limited to the above structure, and the conductive member 3 and the first insulating layer 6 only need to be continuous. Specifically, an end surface of the conductive member 3 and the first insulating layer 6 may be in contact with each other and do not need to overlap each other in plan view.

Note that each of the embodiments is an example, and the present invention is not limited to each of the embodiments. Further, partial replacement or combination of configurations shown in different embodiments is possible.

Note that an aspect of the stretchable device according to an embodiment of the present invention is as described below.
<1> A stretchable device including:
   a stretchable substrate;
   a stretchable wiring provided on the stretchable substrate;
   a conductive member that is in contact with the stretchable wiring;
   a solder member that is provided on the conductive member and is in contact with the conductive member;
   an electronic component electrically connected to the conductive member with the solder member interposed therebetween; and
   a first insulating layer covering at least a part of the stretchable wiring,
   in which an outer surface of an end portion, on a side in contact with the conductive member, of the stretchable wiring is in contact with the conductive member and the first insulating layer continuous with the conductive member.
<2> The stretchable device according to <1>, in which the first insulating layer is in contact with an end portion of the conductive member.
<3> The stretchable device according to <1> or <2>, in which the first insulating layer overlaps an end portion of the conductive member in plan view.
<4> The stretchable device according to <3>, in which a part of the first insulating layer is in contact with both the conductive member and the solder member.
<5> The stretchable device according to any one of <1> to <4>, in which the first insulating layer, the conductive member, and the solder member overlap each other in plan view.
<6> The stretchable device according to <5>, in which a part of the first insulating layer is arranged between the solder member and the conductive member.
<7> The stretchable device according to any one of <1> to <6>, in which a part of the stretchable wiring is arranged on the conductive member, and the first insulating layer is arranged between a part of the stretchable wiring and the solder member.
<8> The stretchable device according to any one of <1> to <7>, in which a part of the stretchable wiring is arranged under the conductive member.
<9> The stretchable device according to any one of <1> to <8>, in which the stretchable wiring includes a first portion having a large thickness and a second portion having a smaller thickness than the first portion, and at least a part of the second portion is arranged under the conductive member.
<10> The stretchable device according to any one of <1> to <9>, in which a part of the stretchable wiring is in contact with an upper surface and a lower surface of the conductive member.
<11> The stretchable device according to any one of <1> to <10>, further including a second insulating layer, in which the second insulating layer is in contact with an end portion on a side opposite to a side in contact with the first insulating layer with reference to the conductive member.
<12> The stretchable device according to <11>, in which a part of the second insulating layers is arranged on the end portion on the opposite side of the conductive member.
<13> The stretchable device according to <11> or <12>, further including a pair of the stretchable wirings that are separated from and face each other,
   in which the second insulating layer is in contact with an end portion on a side opposite to a side in contact with the first insulating layer with reference to the conductive member in contact with one of the stretchable wirings, and an end portion on a side opposite to a side in contact with the first insulating layer with reference to the conductive member in contact with another one of the stretchable wirings.
<14> The stretchable device according to any one of <1> to <13>, further including a protective layer,
   in which the protective layer is arranged between the stretchable wiring and the stretchable substrate.
<15> The stretchable device according to any one of <1> to <14>, further including a resin layer covering the electronic component.
<16> The stretchable device according to any one of <1> to <15>, in which the conductive member contains thermosetting resin.

### INDUSTRIAL APPLICABILITY

The stretchable device according to an embodiment of the present invention can be used in a state where an electronic component is mounted.

### CROSS-REFERENCE TO RELATED APPLICATION

The present application claims the right of priority of Japanese Patent Application No. 2021-199233 (filed on December 8, 2021, the title of the invention: "STRETCHABLE DEVICE"). The disclosure of which is incorporated herein by reference.

### DESCRIPTION OF REFERENCE SYMBOLS

1: Stretchable substrate
2: Stretchable wiring
3: Conductive member
4: Solder member
5: Electronic component
6: First insulating layer
7: First portion
8: Second portion
9: Second insulating layer
10: Protective layer
11: Resin layer
12: Surface of resin layer
13: Contact
21: Upper surface
21A: Uppermost surface
21B: Second upper surface
22: Lower surface
22A: Lowermost surface
22B: Second lower surface
23: Side surface
24: End surface
100, 100A, 100B, 100C, 100D, 100E, 101, 102: Stretchable device

## Claims

1. A stretchable device comprising:
a stretchable substrate;
a stretchable wiring provided on the stretchable substrate;
a conductive member that is in contact with the stretchable wiring;
a solder member that is provided on the conductive member and is in contact with the conductive member;
an electronic component electrically connected to the conductive member with the solder member interposed therebetween; and
a first insulating layer covering at least a part of the stretchable wiring,
wherein an outer surface of an end portion, on a side in contact with the conductive member, of the stretchable wiring is in contact with the conductive member and the first insulating layer continuous with the conductive member.

2. The stretchable device according to claim 1, wherein the first insulating layer is in contact with an end portion of the conductive member.

3. The stretchable device according to claim 1 or 2, wherein the first insulating layer overlaps an end portion of the conductive member in plan view.

4. The stretchable device according to claim 3, wherein a part of the first insulating layer is in contact with both the conductive member and the solder member.

5. The stretchable device according to any one of claims 1 to 4, wherein the first insulating layer, the conductive member, and the solder member overlap each other in plan view.

6. The stretchable device according to claim 5, wherein a part of the first insulating layer is arranged between the solder member and the conductive member.

7. The stretchable device according to any one of claims 1 to 6, wherein a part of the stretchable wiring is arranged on the conductive member, and the first insulating layer is arranged between a part of the stretchable wiring and the solder member.

8. The stretchable device according to any one of claims 1 to 7, wherein a part of the stretchable wiring is arranged under the conductive member.

9. The stretchable device according to any one of claims 1 to 8, wherein the stretchable wiring includes a first portion having a large thickness and a second portion having a smaller thickness than the first portion, and at least a part of the second portion is arranged under the conductive member.

10. The stretchable device according to any one of claims 1 to 9, wherein a part of the stretchable wiring is in contact with an upper surface and a lower surface of the conductive member.

11. The stretchable device according to any one of claims 1 to 10, further comprising a second insulating layer,
wherein the second insulating layer is in contact with an end portion on a side opposite to a side in contact with the first insulating layer with reference to the conductive member.

12. The stretchable device according to claim 11, wherein a part of the second insulating layers is arranged on the end portion on the opposite side of the conductive member.

13. The stretchable device according to claim 11 or 12, further comprising a pair of the stretchable wirings that are separated from and face each other,
wherein the second insulating layer is in contact with an end portion on a side opposite to a side in contact with the first insulating layer with reference to the conductive member in contact with one of the stretchable wirings, and an end portion on a side opposite to a side in contact with the first insulating layer with reference to the conductive member in contact with another one of the stretchable wirings.

14. The stretchable device according to any one of claims 1 to 13, further comprising a protective layer,
wherein the protective layer is arranged between the stretchable wiring and the stretchable substrate.

15. The stretchable device according to any one of claims 1 to 14, further comprising a resin layer covering the electronic component.

16. The stretchable device according to any one of claims 1 to 15, wherein the conductive member contains thermosetting resin.
